(19) **Europäisches Patentamt / European Patent Office / Office européen des brevets**

(11) **EP 1 535 334 B1**

(12) **EUROPÄISCHE PATENTSCHRIFT**

(45) Veröffentlichungstag und Bekanntmachung des Hinweises auf die Patenterteilung:
**24.10.2007 Patentblatt 2007/43**

(21) Anmeldenummer: **03793745.5**

(22) Anmeldetag: **21.08.2003**

(51) Int Cl.:
*H01L 27/115* (2006.01)     *H01L 21/8246* (2006.01)

(86) Internationale Anmeldenummer:
**PCT/EP2003/009294**

(87) Internationale Veröffentlichungsnummer:
**WO 2004/023556 (18.03.2004 Gazette 2004/12)**

(54) **WORT- UND BITLEITUNGSANORDNUNG FÜR EINEN FINFET- HALBLEITERSPEICHER**

WORD AND BIT LINE ARRANGEMENT FOR A FINFET SEMICONDUCTOR MEMORY

AGENCEMENT DE LIGNES DE MOTS ET DE BITS POUR UNE MEMOIRE A SEMICONDUCTEURS FINFET

(84) Benannte Vertragsstaaten:
**DE FR GB IE IT NL**

(30) Priorität: **05.09.2002 DE 10241171**

(43) Veröffentlichungstag der Anmeldung:
**01.06.2005 Patentblatt 2005/22**

(73) Patentinhaber: **Qimonda AG**
**81739 München (DE)**

(72) Erfinder:
  • **HOFMANN, Franz**
    **80995 München (DE)**
  • **SCHULZ, Thomas**
    **3001 Heverlee (BE)**

  • **SPECHT, Michael**
    **80799 München (DE)**

(74) Vertreter: **Müller-Boré & Partner**
**Patentanwälte**
**Grafinger Strasse 2**
**81671 München (DE)**

(56) Entgegenhaltungen:
**US-A- 5 959 328        US-A1- 2002 020 890**
**US-B1- 6 274 453        US-B1- 6 413 802**

  • **PATENT ABSTRACTS OF JAPAN vol. 1996, no. 05, 31. Mai 1996 (1996-05-31) & JP 08 017942 A (NEC CORP), 19. Januar 1996 (1996-01-19)**

EP 1 535 334 B1

**Beschreibung**

Die Erfindung betrifft einen Halbleiterspeicher gemäß Anspruch 1.

Konventionelle nichtflüchtige Halbleiterspeicherelemente existieren je nach Anwendung in einer Vielzahl verschiedener Ausführungen, z.B. PROM, EEPROM, FLASH EEPROM sowie SONOS. Diese unterschiedlichen Ausführungen unterscheiden sich insbesondere in Löschoption, Programmierbarkeit und Programmierzeit, Haltezeit, Speicherdichte sowie in ihren Herstellungskosten. Ein besonderer Bedarf besteht an hochdichten und preiswerten FLASH-Halbleiterspeicherelementen. Bekannte Ausführungen sind insbesondere sogenannte NAND und ETOX-Speicherzellen, deren Speicherdichte jedoch mehr als $4F^2$ erfordert, wobei F die kleinste im Prozeß vorkommende Strukturabmessung des Halbleiterspeichers ist.

In der Veröffentlichung von B. Eitan et al. "NROM: A novel localized trapping, 2-bit nonvolatile Memory Cell", IEEE Electron Device Letters vol. 21, n. 11 November 2000, ist eine sogenannte NROM-Speicherzelle beschrieben, welche mit Hilfe einer Zelle, welche 2 Bit speichern kann, eine Zelle mit einem Flächenmaß von $2F^2$ ermöglicht. Jedoch ist die Skalierbarkeit derartiger NROM-Speicherzellen, welche planare Bauelemente darstellen, wie auch bei anderen herkömmlichen EEPROM-Speichern mit Trapping-Schichten (beispielsweise Oxid-Nitrid-Oxid-Trapping-Schichten, sogenannte ONO-Stacks) begrenzt. Derartige Bauelemente nutzen in bekannter Weise zum Programmieren der Trapping-Schicht heiße Kanalelektronen, welche durch geeignete Potentialverhältnisse am Source-, Drain- und Gatekontakt vom Transistorkanal in die Trapping-Schicht injiziert werden (channel hot electron, CHE).

Das oben genannte Skalierungsproblem kann durch Speicheranordnungen mit sogenannten FINFETs, bei welchen der Transistorkanal in einer stegartigen Rippe aus Halbleitermaterial ausgebildet ist, verbessert werden. Von Vorteil ist hierbei ferner, daß der Lesestrom des Speicherelements durch die Höhe der Rippe, welche auch als Finne bezeichnet wird, eingestellt werden kann. Da die Gateelektroden bei derartigen FINFET-Speicheranordnungen die rippenartigen Transistorkanalbereiche von drei Seiten umgeben, können bei geeigneter Wahl der Transistorparameter Kurzkanaleffekte, welche die Skalierbarkeit einschränken, wirksam unterdrückt werden.

Als besonders vorteilhaft wurden FINFET-Speicheranordnungen vorgeschlagen (vgl. DE 102 11 931.7), bei welchen die Wortleitung parallel zur Rippenlängsrichtung (Finnenrichtung) verlief. Bei sehr hohen Zellenfelddichten derartiger Halbleiterspeicher kamen FINFET-Speicheranordnungen zum Einsatz, bei welchen die voneinander beabstandeten und parallel zueinander angeordneten Silizium-Rippen weniger als 50 nm voneinander entfernt sind (kleinste Strukturgröße F kleiner als 50 nm). Die Wortleitungen, welche zwischen zwei benachbarten Rippen in Richtung von deren Rippenlängsachsen verlaufen können sich jedoch bei derartigen Abmessungen leicht kurzschließen.

US-A-5 959 328 offenbart einen Halbleiterspeicher mit stegartigen Rippen. US-B1-6 274 453 offenbart einen Halbleiterspeicher mit stegartigen Rippen und schrägen Bitleitungen. JP 08 017942 A offenbart gewinkelte Bitleitungsteilstücke.

Aufgabe der Erfindung ist es demgemäß, einen Halbleiterspeicher anzugeben, welcher ein hochdichtes Zellenfeld ermöglicht, ohne die obigen Kurzschlußprobleme aufzuweisen.

Diese Aufgabe wird durch einen Halbleiterspeicher mit den in Anspruch 1 genannten Merkmalen gelöst. Bevorzugte Ausführungsformen sind Gegenstand der abhängigen Ansprüche.

Erfindungsgemäß umfaßt ein Halbleiterspeicher

- eine Vielzahl voneinander beabstandeter stegartiger Rippen aus Halbleitermaterial, deren Rippenlängsrichtungen parallel zueinander verlaufen, wobei in jeder der Rippen eine Vielzahl von Kanalbereichen und leitfähig dotierten Kontaktbereichen ausgebildet ist und die Kanal- und die Kontaktbereiche in Rippenlängsrichtung alternierend hintereinander angeordnet sind;
- eine Vielzahl von senkrecht zu der Rippenlängsrichtung angeordneten zueinander parallelen Wortleitungen, welche als Gateelektroden über eine Vielzahl der Kanalbereiche zur Steuerung von deren elektrischen Leitfähigkeiten verlaufen, wobei die Wortleitungen gegenüber den Kontakt- und den Kanalbereichen elektrisch isoliert sind;
- eine Vielzahl von zum Einfangen und Abgeben von Ladungsträgern ausgelegten Speicherschichten, wobei zwischen jedem der Kanalbereiche und der diesem Kanalbereich zugeordneten Wortleitung zumindest eine der Speicherschichten umgeben von einer Isolatorschicht angeordnet ist; und
- eine Vielzahl von Bitleitungen,

  -- welche schräg zur Wortleitungslängsrichtung und schräg zu der Rippenlängsrichtung angeordnet sind,
  -- wobei die Bitleitungen jeweils aus zumindest einem ersten und einem zweiten Bitleitungsteilstück bestehen,
  -- die Längsachsen der ersten Bitleitungsteilstücke parallel zu einer ersten und die Längsachsen der zweiten Bitleitungsteilstücke parallel zu einer zweiten Bitleitungsrichtung verlaufen, wobei die zweite Bitleitungsrichtung um einen von Null Grad verschiedenen Winkel gegenüber der ersten Bitleitungsrichtung verdreht ist; und jede der Bitleitungen mit einer Vielzahl der Kontaktbereiche elektrisch verbunden ist, wobei zwischen zwei mit einer der Bitleitungen verbundenen Kontaktbereichen derselben Rippe ein nicht mit dieser Bitleitung verbundener Kontaktbereich angeordnet ist.

Der erfindungsgemäße Halbleiterspeicher nutzt als "Speichertransistoren" sogenannte FINFETs. Hierbei ist der Transistorkanal in einer stegartigen Halbleiterrippe mit in Rippenlängsrichtung angrenzenden dotierten Kontaktbereichen ausgebildet. Die elektrische Leitfähigkeit des Transistorkanals, d.h. des Kanalbereichs, ist über eine (Kontroll- bzw. Steuer-)Gateelektrode in bekannter Weise über den Feldeffekt steuerbar. Zwischen der Gateelektrode, welche eine der Wortleitungen des Halbleiterspeichers darstellt, und dem Kanalbereich ist eine Speicherschicht angeordnet. Die Speicherschicht ist gegenüber ihrer Umgebung, insbesondere gegenüber dem Kanalbereich und der Gateelektrode, mittels einer dünnen Isolatorschicht elektrisch getrennt. Jedoch können Ladungsträger, beispielsweise Elektronen bei einem n-Kanal FINFET, bei geeigneten Source-, Drain- und Gatepotentialen eine derartige Energie erlangen (heiße Elektronen), daß sie die dünne Isolatorschicht überwinden und von der Speicherschicht dauerhaft eingefangen werden können. Eine so in die Speicherschicht eingebrachte Ladung kann zur Speicherung eines "Bits" in nicht-flüchtiger Weise herangezogen werden, da sie einen Einfluß auf die Kennlinie, insbesondere die Einsatzspannung (Threshold-Spannung), des FINFETs hat. Diese unterschiedlichen Threshold-Spannungen können zum "Auslesen" der Speicherzelle herangezogen werden. Insbesondere kann in diesem Zusammenhang das in der obigen Veröffentlichung von B. Eitan et al. beschriebene Leseverfahren, welches ebenfalls in der internationalen Patentanmeldung WO 99/07000 beschrieben ist, verwendet werden. Hinsichtlich des Programmier-, Lese- und Löschverfahrens des erfindungsgemäßen Halbleiterspeichers wird somit in vollem Umfang auf diese obigen Veröffentlichungen Bezug genommen, welche insoweit einen integralen Offenbarungsteil der vorliegenden Anmeldung bilden.

Das eingangs genannte Problem, daß sich bei hochdichten Speicherzellenfeldern parallel zu der Rippenlängsrichtung verlaufende Wortleitungen zwischen zwei benachbarten Rippen kurzschließen können, löst die Erfindung dadurch, daß die Wortleitungen im wesentlichen senkrecht zu der Rippenlängsrichtung angeordnet sind. Gleichzeitig sind die Bitleitungen, über welche die hochdotierte Kontaktbereiche (Source- und Drain-Kontakte) der FINFETs kontaktierbar sind, schräg zu der Rippenlängsrichtung sowie ebenfalls schräg zu der Wortleitungsrichtung angeordnet. Es besteht somit ein von 0° verschiedener Winkel zwischen den Wortleitungen und jeder der Bitleitungen. Gleichermaßen besteht ein von 0° verschiedener Winkel zwischen der Rippenlängsrichtung und der Längsrichtung der Bitleitung.

Eine weitere erfindungsgemäße Maßnahme, welche die Eigenschaften des Halbleiterspeichers verbessert, ist darin zu sehen, daß jede der Bitleitungen aus zumindest zwei Bitleitungsteilstücken besteht. Die beiden Bitleitungsteilstücke jeder Bitleitung sind in der Bitleitungsebene um einen Winkel zueinander verdreht, so daß die erste Bitleitungsrichtung nicht mit der zweiten Bitleitungsrichtung übereinstimmt. Hierdurch werden große Längenunterschiede zwischen den Bitleitungen vermieden, welche zu Schwierigkeiten beim Auslesen des Speicherzellenfeldes aufgrund unterschiedlicher Bitleitungsimpedanzen, Laufzeiteffekte etc. führen könnten. Würden die Bitleitungen aus einem einzigen geraden Teilstück bestehen, welches schräg zu der Wortleitungslängsrichtung sowie den Rippenlängsachsen angeordnet ist, ergeben sich im Extremfall Bitleitungen, welche lediglich einen einzigen Kontaktbereich elektrisch verbinden und Bitleitungen, welche sich entlang der gesamten Diagonale des Speicherzellenfeldes erstrecken.

Die beiden Bitleitungsteilstücke sind vorzugsweise unmittelbar über einem Kontaktbereich miteinander verbunden, so daß die "Richtungsänderung" der Bitleitung im Bereich der hochdotierten Kontaktbereiche erfolgt. Zwischen diesen "Richtungsänderungen" erstrecken sich die Bitleitungsteilstücke als gerade Metallbahnen in einer Bitleitungsebene.

Vorteile des erfindungsgemäßen Halbleiterspeichers sind ein variabel einstellbarer Lesestrom durch die Variation der Höhe der Rippe, welcher auf "high performance" oder "low-power" Anwendungen abstimmbar ist. Die sogenannte "double gate"-Wirkung der FINFET Anordnung gestattet eine potentiell bessere Skalierbarkeit im Vergleich zu planaren Bauelementen, beispielsweise NROM Speichern. Ferner gestattet der erfindungsgemäße Halbleiterspeicher aufgrund der metallischen Bitleitungen schnellere Zugriffszeiten durch geringere Leitungswiderstände (kleinere RC-Zeiten beim Treiben parasitärer Kapazitäten). Die neuartige Anordnung von Wort- und Bitleitungen ermöglicht besonders hohe Speicherdichten auch für sehr geringe Rippenabstände von weniger als 50 nm (F < 50 nm).

Vorzugsweise besteht jede der Bitleitungen aus einer Vielzahl von Bitleitungsteilstücken mit alternierender erster und zweiter Bitleitungsrichtung. Die Bitleitungen weisen vorzugsweise eine sogenannte Sägezahnform auf, bei welchen die Bitleitungen Sägezahn- bzw. Zick-Zack-förmig in einer Bitleitungsebene angeordnet sind. Die Bitleitungsrichtung von miteinander verbundenen Bitleitungsteilstücken wechseln sich hierbei entlang der Bitleitung zwischen der ersten und der zweiten Bitleitungsrichtung ab.

Vorzugsweise weisen die Bitleitungsteilstücke identische Längen auf. Vorzugsweise sind sämtliche Bitleitungen als regelmäßige Sägezahnmuster ausgestaltet, deren Zähne teilweise ineinandergreifen, so daß das Zellenfeld (bis auf eventuelle Randbereiche) vollständig ankontaktierbar ist.

Vorzugsweise ist eine Anzahl $N_{Rippen}$ der Rippen in jedem Speichersektor vorgesehen und jedes der Bitleitungsteilstücke ist mit höchstens $N_{Rippen}/10$ von in Bitleitungsrichtung benachbarten Kontaktbereichen unterschiedlicher Rippen elektrisch verbunden. Somit erstrecken sich die Bitleitungsteilstücke nur über einen kleinen Teil des gesamten Zellenfeldes und kreuzen insbesondere höchstens ein Zehntel der im Zellenfeld vorhandenen Rippen. Bei typischen Zellenfeldgrößen von 256 x 256 Wort- und Bitleitungen liegt somit die "Amplitude" des Sägezahnmusters bei weniger als etwa 25 Rippen, vorzugsweise weniger als 10 Rippen.

Besonders bevorzugt ist eine Anordnung, bei welcher jede Bitleitung sägezahnförmig die im Zellenfeld diagonal benachbarten Kontaktbereiche elektrisch verbindet. Bei einer derartigen Bitlineanordnung findet demgemäß ein "Richtungswechsel" auf jedem elektrisch mit der Bitleitung verbundenen Kontaktbereich statt.

Vorzugsweise weisen die Bitleitungen identische Flächengestalten auf. Insbesondere lassen sich die Flächengestalten in der Bitleitungsebene durch eine Parallelverschiebung entlang der Wortleitungslängsrichtung um eine Rippenperiode (pitch) ineinander überführen.

Vorzugsweise ist jede der Bitleitungen mit mindestens $N_{min}$ und höchstens $N_{max}$ der Kontaktbereiche verbunden, so daß $(N_{max} - N_{min}) / N_{max} < 20\%$ gilt. Die relative Abweichung der Anzahl der Kontaktbereiche, mit welchen die Bitleitungen elektrisch verbunden sind, liegt somit in einer Schwankungsbreite von weniger als 10%. Somit weisen die Bitleitungen nur geringfügig unterschiedliche Anzahlen von mit ihnen elektrisch verbundenen Kontaktbereichen auf. Dies führt zu einer nur geringen Variation von elektrischen Kenngrößen der Bitleitung, insbesondere deren Impedanz, so daß eine an den Bitleitungen angeschlossene Auswerteelektronik einfacher abzustimmen ist. Im Idealfall weisen sämtliche Bitleitungen eine im wesentlichen identische Anzahl von mit ihnen verbundenen Kontaktbereichen auf, so daß die Bitleitungen die gleiche "elektrische Länge" haben.

Vorzugsweise ist die Rippenbreite gleich der Wortleitungbreite und gleich dem senkrechten Abstand zwischen benachbarten Wortleitungen. Die Rippenbreite, d.h. der senkrechte Abstand der gegenüberliegenden parallel verlaufenden Rippenseitenflächen, wird vorzugsweise gleich zu der Wortleitungsbreite und dem Wortleitungsabstand gewählt, so daß ein quadratisches 1:1 Zellenfeldraster entsteht. Eine derartige Zellenfeldanordnung ermöglicht die höchste Speicherdichte.

Vorzugsweise sind zwei Bitleitungsebenen vorgesehen und in Wortleitungslängsrichtung benachbarte Bitleitungen sind in unterschiedlichen Bitleitungsebenen angeordnet. Eine derartige Ausführungsform ist insbesondere dann interessant, wenn - wie oben beschrieben - die Rippenbreite, Bitleitungsbreite, Wortleitungsbreite und der Wortleitungsabstand der minimalen Strukturgröße F des Halbleiterspeichers entsprechen. In einem derartigen Fall führt eine sägezahnförmige Bitleitung zu Abständen von benachbarten Bitleitungen, welche kleiner als die minimale Strukturgröße F liegen würden. Dieses Problem kann dadurch gelöst werden, daß jeweils benachbarte Bitleitungen in unterschiedlichen Bitleitungsebenen, d.h. in unterschiedlichen Metallebenen, angeordnet sind. Beispielsweise sind die ungeraden Bitleitungen in einer ersten Bitleitungsebene und die geraden Bitleitungen in einer zweiten, vom Halbleitersubstrat weiter entfernten (höher gelegenen) Bitleitungsebene vorgesehen. Die höhere Bitleitungsebene wird durch tiefe Kontaktlöcher mit den anzuschließenden Kontaktbereichen der FINFETs verbunden. Mit einer derartigen Bitleitungsanordnung läßt sich eine $4F^2$-Speicherzelle, welche zwei Bit speichern kann, erzielen. Hierbei kommt das von NROM-Speichern bekannte Programmier- und Lesekonzept zum Einsatz.

Vorzugsweise sind die Bitleitungsrichtungen gegenüber der Wortleitungs- und der Rippenlängsrichtung um einen Winkel von etwa 45° verdreht und der Winkel zwischen der ersten und der zweiten Bitleitungsrichtung beträgt 90°. Eine derartige Anordnung ist insbesondere bei einem Speicherzellenfeld mit einer quadratischen 1:1 Anordnung der Zellen vorteilhaft und erlaubt eine symmetrische Ausgestaltung der Bitleitungen.

Vorzugsweise sind die Speicherschichten Trapping-Schichten (sogenannte trapping layers) und die Isolatorschichten Oxidschichten. Besonders bevorzugt ist die Trapping-Schicht eine Nitridschicht, insbesondere eine Siliziumnitridschicht, welche von Oxidschichten, insbesondere Siliziumdioxidschichten, umgeben ist. Eine derartige Oxid-Nitrid-Oxid-Anordnung zwischen der (Steuer-)Gateelektrode und dem Kanalbereich wird als ONO-Stack bezeichnet. Es können jedoch auch andere Trapping-Materialien zum Einsatz kommen, beispielsweise sogenanntes "silicon-rich oxide" oder auch undotiertes Polysilizium oder andere high-k Materialien. Derartige Trapping-Schichten weisen eine große Dichte von Störstellenzuständen (sogenannten "trap-Zuständen") auf, welche zum Einfangen und Abgeben von Ladungsträgern (Elektronen oder Löchern) geeignet sind.

Die Erfindung stellt somit vorzugsweise einen nichtflüchtigen Halbleiterspeicher in "virtual ground"-Anordnung (VGA) mit einer Zellenfelddichte von $2F^2$ pro Bit bereit, bei welchem die Bitleitungen sägezahnförmig und alternierend in der ersten und zweiten Metallebene (Bitleitungsebene) liegen. Hierdurch wird eine Speicheranordnung mit der Speicherdichte von planaren NROMs mit dem Vorteil eines einstellbaren Lesestroms, der "double gate"-Wirkung durch die FINFET-Anordnung und einer somit potentiell besseren Skalierbarkeit sowie einer schnelleren Zugriffzeit auf jede Speicherzelle durch die metallischen Bitleitungen erzielt. Die sehr hohe Speicherdichte von $2F^2$ pro Bit ist auch für sehr eng liegende Rippen (Finnen) mit F<50 nm erzielbar.

Nachfolgend wird die Erfindung mit Bezug auf begleitende Zeichnungen bevorzugter Ausführungsformen beispielhaft beschrieben. Es zeigt:

Fig. 1    Eine vereinfachte schematische Querschnittsansicht einer ersten FINFET-Anordnung, welche sich besonders für einen erfindungsgemäßen Halbleiterspeicher eignet;

Fig. 2 eine vereinfachte schematische Querschnittsansicht einer zweiten FINFET-Anordnung, welche sich besonders für einen erfindungsgemäßen Halbleiterspeicher eignet;

Fig. 3 eine vereinfachte schematische Querschnittsansicht einer dritten FINFET-Anordnung, welche sich besonders für einen erfindungsgemäßen Halbleiterspeicher eignet;

Fig. 4 eine vereinfachte Aufsicht auf ein Speicherzellenfeld einer bevorzugten Ausführungsform eines erfindungsgemäßen Halbleiterspeichers, bei welchem die sägezahnförmigen Bitleitungen alternierend in der ersten und zweiten Metallebene angeordnet sind;

Fig. 5 eine stark vereinfachte Querschnittsansicht entlang der Linie A-A von Fig. 4 zum Verdeutlichen des Verlaufs der Bitleitungen; und

Fig. 6 eine vereinfachte Aufsicht auf ein Speicherzellenfeld einer weiteren bevorzugten Ausführungsform eines erfindungsgemäßen Halbleiterspeichers, bei welchem die sägezahnförmigen Bitleitungen in derselben Metallebene verlaufen.

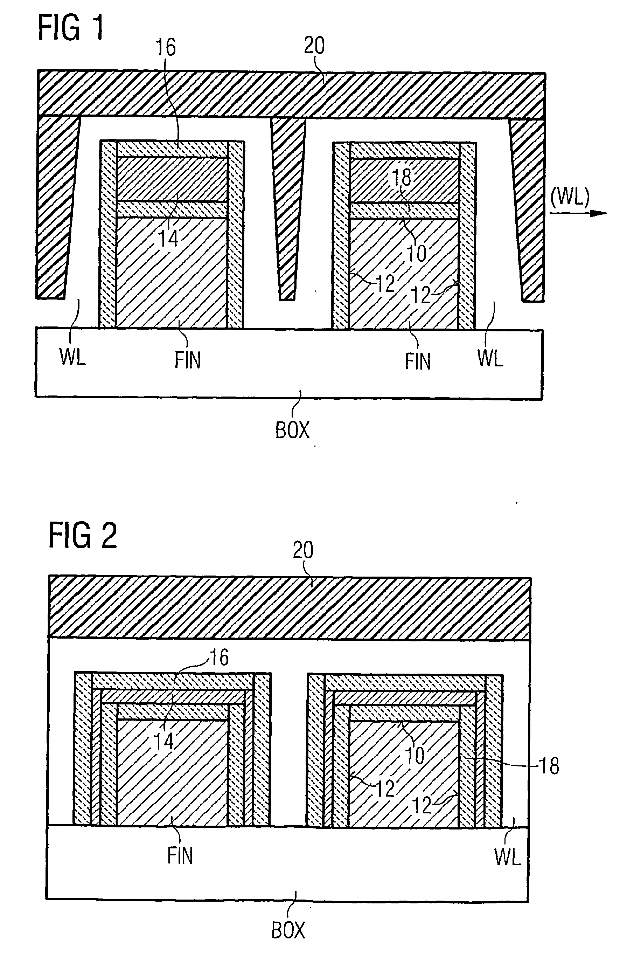

**Fig. 1** zeigt eine vereinfachte Querschnittsansicht einer FINFET-Anordnung, welche sich besonders für einen erfindungsgemäßen Halbleiterspeicher eignet. Zur besseren Übersichtlichkeit wurde bei dieser Querschnittsansicht auf die Einzeichnung von Bitleitungen und höherliegenden Strukturen verzichtet.

Die Querschnittsansicht, welche in Fig. 1 dargestellt ist, verläuft in einer Ebene, welche senkrecht zu der Rippenlängsrichtung der Rippen FIN steht. Die Rippen FIN weisen bei dieser Ausführungsform einen im wesentlichen rechtecksförmigen Querschnitt mit einer Rippenoberseite 10 und gegenüberliegenden Rippenseitenflächen 12 auf. Die Schnittebene von Fig. 1 verläuft durch eine Wortleitung WL entlang deren Längsrichtung. Die Wortleitungslängsrichtung ist mit einem mit (WL) bezeichneten Richtungspfeil veranschaulicht. Zwischen der Wortleitung WL und dem in der Rippe FIN gebildeten Kanalbereich ist eine Speicherschicht 14 vorgesehen, bei welcher es sich um eine Trapping-Schicht handelt. Vorzugsweise besteht die Speicherschicht 14 aus Nitrid, welches von dünnen Oxidwänden 16 umgeben ist.

Im Transistorkanal durch geeignete Potentialverhältnisse erzeugte heiße Elektronen können als sogenannte "channel hot electrons (CHE)" die Oxidschicht 18 überwinden und in die Speicherschicht 14 eindringen. Ihre Anwesenheit in der Speicherschicht 14 bewirkt in bekannter Weise eine Verschiebung der Einsatzspannung (Threshold-Spannung) des FINFETs, wodurch ein "Bit" programmiert werden kann. Die Skalierbarkeit des FINFETs ist aufgrund der "double gate" Wirkung der Wortleitung WL auf den Kanalbereich, insbesondere von den Rippenseitenflächen 12 aus, gegenüber planaren Bauelementen verbessert. Zur Herstellung derartiger FINFET-Anordnungen eignen sich insbesondere SOI-Substrate (silicon on insulator), bei welchen die stegartigen Rippen aus Halbleitermaterial, vorzugsweise Silizium, auf einer vergrabenen Oxidschicht BOX angeordnet sind, welche ihrerseits auf einem Siliziumsubstrat aufgebracht ist. Die Rippen FIN sind in der Top-Siliziumschicht (body-Siliziumschicht) ausgebildet.

Die Breite der in Fig. 1 dargestellten Rippen FIN, d.h. der senkrechte Abstand zwischen gegenüberliegenden Rippenseitenflächen 12, ist vorzugsweise kleiner als 100 nm, besonders bevorzugt kleiner als 50 nm. Die gesamte Struktur ist von einer Isolatorschicht 20, insbesondere einer Nitridschicht, umgeben.

**Fig. 2** zeigt eine weitere bevorzugte FINFET-Anordnung, welche besonders für einen erfindungsgemäßen Halbleiterspeicher geeignet ist. Die Schnittrichtung entspricht hierbei derjenigen von Fig. 1 und gleiche oder ähnliche Merkmale sind mit identischen Bezugszeichen versehen, so daß auf eine erneute Beschreibung verzichtet werden kann.

Während bei der in Fig. 1 dargestellten FINFET-Anordnung die Speicherschicht 14 durch eine Oxidschicht 18 von der Rippenoberseite 10 beabstandet angeordnet ist, erstreckt sich die Speicherschicht 14 bei der in Fig. 2 dargestellten Variante auch entlang den Rippenseitenflächen 12. In üblicher Weise ist die Speicherschicht 14 gegenüber den (nicht dargestellten) Kontaktbereichen und dem Kanalbereich der Rippe FIN sowie der Wortleitung (Gateelektrode) durch Isolatorschichten 16, 18 getrennt. Vorzugsweise handelt es sich bei der zwischen der Wortleitung WL und der Rippe FIN liegenden Speicherschichtanordnung um einen sogenannten ONO-Stack, bei welchem eine Siliziumnitridschicht zwischen zwei Siliziumdioxidschichten eingebettet ist. Entsprechend dem Verlauf der Speicherschicht 14 wird die in Fig. 2 dargestellte FINFET-Variante als sogenannter "wrap around" Speicherfinfet bezeichnet.

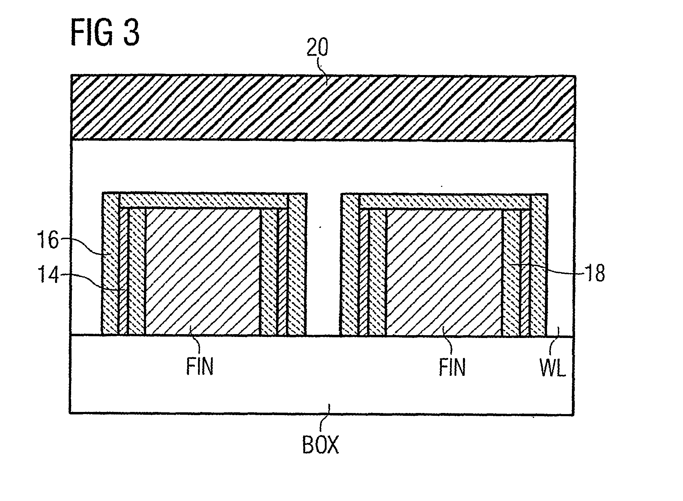

In **Fig. 3** ist eine weitere Variante einer FINFET-Anordnung dargestellt, welche sich ebenfalls in besonderer Weise für einen erfindungsgemäßen Halbleiterspeicher eignet. Die Schnittebene von Fig. 3 entspricht derjenigen von Figs. 1 und 2. Im Unterschied zu Fig. 2 ist bei der in Fig. 3 dargestellten FINFET-Variante die Speicherschicht 14 lediglich entlang den Rippenseitenflächen 12 getrennt von einer Isolatorschicht 18 angeordnet. Auf der Rippenoberseite 10 ist hingegen keine Speicherschicht 14 vorgesehen, so daß ein sogenannter "zwei-Seiten-ONO"-Speicher-FINFET gebildet wird.

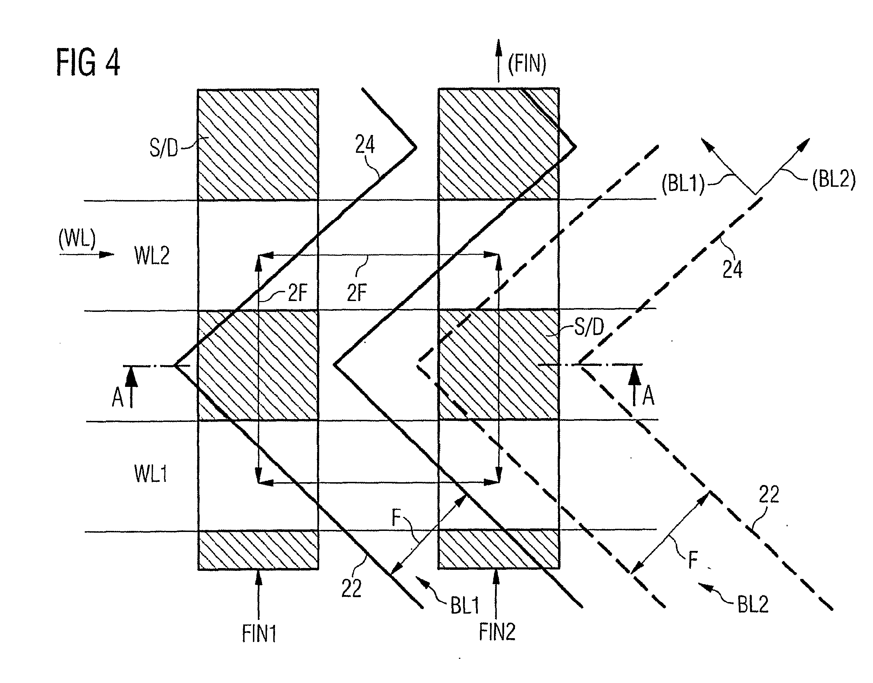

**Fig. 4** zeigt eine vereinfachte Aufsicht einer ersten bevorzugten Ausführungsform eines erfindungsgemäßen Halbleiterspeichers.

Die stegartigen Rippen aus Halbleitermaterial FIN1, FIN2 verlaufen in der Zeichenebene von oben nach unten. Die Rippenlängsrichtung ist durch den mit (FIN) bezeichneten Richtungspfeil veranschaulicht. Die Rippen FIN1, FIN2 weisen in der in Fig. 4 dargestellten Ausführungsform eine Rippenbreite F auf, welcher der minimalen Strukturbreite des Halbleiterspeichers entspricht. In Rippenlängsrichtung (FIN) sind alternierend hoch- und niederdotierte Halbleiterabschnitte vorgesehen. Die hochdotierten Abschnitte, welche in Fig. 4 durch ein Punktmuster hervorgehoben sind, bilden die elektrisch leitfähig dotierten Kontaktbereiche S/D (Source- und Drain-Bereiche der FINFETs). Zwischen zwei in Finnenlängsrichtung (FIN) benachbarten Kontaktbereichen S/D ist jeweils ein Kanalbereich angeordnet, in welchem der FINFET-Kanal ausgebildet ist.

Senkrecht zu der Rippenlängsrichtung (FIN) verlaufen die Wortleitungen WL1, WL2. Die Richtung der Wortleitungen ist durch den mit (WL) bezeichneten Richtungspfeil veranschaulicht. Die Wortleitungen WL1, WL2 bilden die (Steuer-)Gateelektroden der FINFETs und verlaufen über den Kanalbereichen der Rippen FIN1, FIN2. Jede Wortleitung WL1, WL2 weist genau einen Kreuzungspunkt mit jeder Rippe FIN1, FIN2 auf. Bei der in Fig. 4 dargestellten Ausführungsform beträgt die Breite der Wortleitungen WL1, WL2 sowie der Abstand benachbarter Wortleitungen F, d.h. die minimale Strukturbreite des Halbleiterspeichers. Bitleitungen BL1, BL2 verlaufen sägezahnförmig über dem durch die Wortleitungen WL1, WL2 und die Rippen FIN1, FIN2 gebildeten matrixförmigen Zellenfeld.

Die Bitleitungen BL1, BL2 sind aus einer Vielzahl von miteinander verbundenen Bitleitungsteilstücken 22, 24 zusammengesetzt. Das erste Bitleitungsteilstück 22 verläuft in einer ersten Bitleitungsrichtung (BL1), während das zweite Bitleitungsteilstück 24 entlang einer zweiten Bitleitungsrichtung (BL2) verläuft. Die Bitleitungsrichtungen (BL1), (BL2) verlaufen schräg zu der Wortleitungslängsrichtung (WL) sowie der Finnenlängsrichtung (FIN). Bei der in Fig. 4 dargestellten Ausführungsform beträgt der Neigungswinkel der Bitleitungsrichtungen (BL1), (BL2) zu der Wortleitungslängsrichtung (WL) und der Finnenlängsrichtung (FIN) jeweils etwa 45°. Vorzugsweise verläuft jede der Bitleitungen BL1, BL2 sägezahnförmig zwischen zwei benachbarten Rippen FIN. Beispielsweise verläuft die Bitleitung BL1 sägezahlförmig zwischen der Rippe FIN1 und der Rippe FIN2, wobei jedes der Bitleitungsteilstücke 22, 24 sich in Bitleitungsrichtung (BL1) bzw. (BL2) zwischen den Rippen FIN1 und FIN2 erstreckt.

Die Bitleitungen BL1, BL2 verlaufen über die Kontaktbereiche S/D, welche in den Rippen FIN1, FIN2 ausgebildet sind. Durch Kontaktlöcher sind die metallischen Bitleitungen BL mit den darunter liegenden Kontaktbereichen F/D elektrisch verbunden. Bei der in Fig. 4 dargestellten Ausführungsform ist die Breite der Bitleitungen BL gleich der minimalen Strukturbreite F des Halbleiterspeichers. Dies führt dazu, daß der minimale Abstand benachbarter Bitleitungen BL in einer Bitleitungsebene kleiner als die minimale Strukturgröße F ausfallen würde. Dieses Problem wird dadurch gelöst, daß die Bitleitungen BL abwechselnd in der ersten und zweiten Metallebene (erste und zweite Bitleitungsebene) ausgebildet sind. Beispielsweise ist die Bitleitung BL1 in der ersten (untersten) Metallebene gebildet und in Fig. 4 mit durchgezogenen Linien dargestellt. Die Bitleitung BL2 ist hingegen in der nächsthöheren zweiten Metallebene gebildet und als Punktlinie in Fig. 4 eingezeichnet. Hierdurch wird ein hochdichtes Speicherzellenfeld mit einer $4F^2$-Speicherzelle, welche zwei Bit speichern kann, ermöglicht. Die $4F^2$-Speicherzelle ist schematisch in Fig. 4 eingezeichnet.

Zwar stellt der in Fig. 4 eingezeichnete sägezahnförmige Bitleitungsverlauf die am meisten bevorzugte Ausführungsvariante eines erfindungsgemäßen Halbleiterspeichers dar, jedoch können auch andere, schräg verlaufende Bitleitungsmuster zum Einsatz kommen. Bevorzugt ist beispielsweise eine Bitleitungsanordnung, welche nicht nur lediglich zwei benachbarte Rippen FIN1, FIN2 miteinander verbindet, sondern eine größere Anzahl (beispielsweise weniger als 20, vorzugsweise weniger als 10). Das Verlaufsmuster der Bitleitungen BL ist vorzugsweise in den Bitleitungsebenen identisch, so daß die Bitleitungen BL dieselbe Flächengestalt aufweisen. Insbesondere läßt sich jede Bitleitung durch eine Parallelverschiebung in Wortleitungslängsrichtung (WL) um eine Rippenperiode (pitch; 2F) in die Flächengestalt der benachbarten Bitleitung überführen.

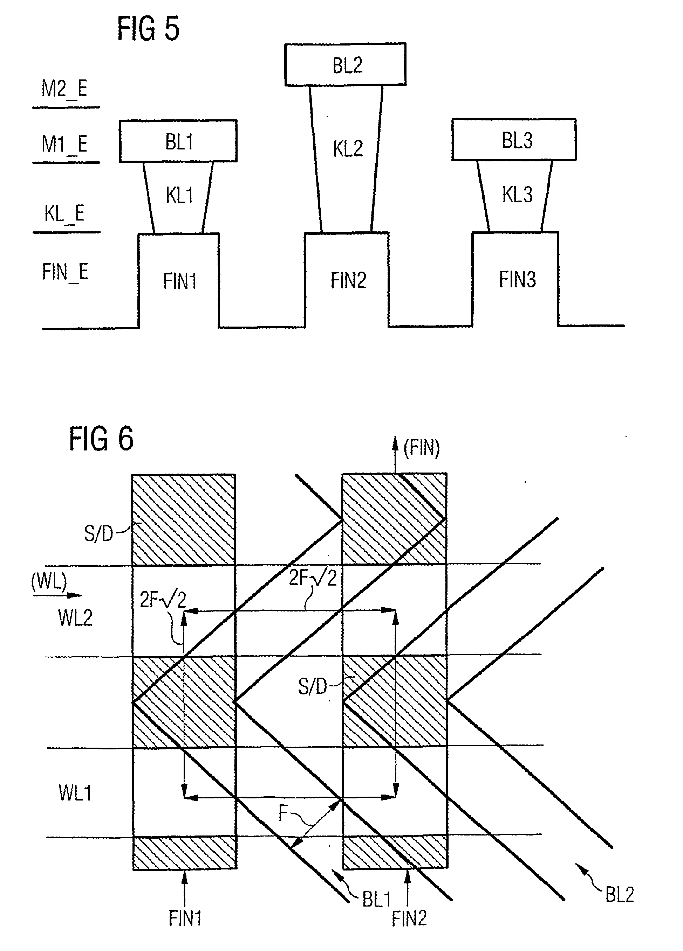

Fig. 5 zeigt eine stark vereinfachte Querschnittsansicht entlang der Linie A-A von Fig. 4. Die Rippen FIN1, FIN2 und FIN3 sind nur schematisiert dargestellt. Die Rippen FIN1, Fin 2, FIN3 sind in der mit FIN_E bezeichneten FINFET-Ebene ausgebildet. Oberhalb der FINFET-Ebene FIN_E ist eine Kontaktlochebene KL_E vorhanden, durch welche sich die Kontaktlöcher KL von der darüberliegenden ersten Metallebene M1_E zu den Kontaktbereichen S/D der FINFETs erstrecken. Zwischen zwei Bitleitungen BL1, BL3, welche in der ersten Metallebene (erste Bitleitungsebene) M1_E ausgebildet sind, befindet sich eine Bitleitung BL2, welche in der darüberliegenden zweiten Metallebene M2_E verläuft. Die metallische Bitleitung BL2 ist über ein "tiefes" Kontaktloch KL mit dem Kontaktbereich S/D der Rippe FIN2 verbunden. Die Bitleitungen BL verlaufen somit abwechselnd in der ersten M1_E und zweiten M2_E Metallebene, so daß der Ebenenabstand kleiner als die minimale Strukturgröße F sein kann.

Fig. 6 zeigt eine zweite bevorzugte Ausführungsform eines erfindungsgemäßen Halbleiterspeichers in schematisierter Aufsicht. Bereits in Zusammenhang mit Fig. 4 beschriebene Merkmale tragen gleiche Bezugszeichen und werden nicht erneut beschrieben. Im Unterschied zu der anhand von Fig. 4 beschriebenen Ausführungsform weist das Speicherzellenfeld von Fig. 6 lediglich Bitleitungen BL in einer einzigen Metallebene (Bitleitungsebene) auf. Bei einer minimalen Strukturbreite F des Halbleiterspeichers, welche der Breite der Bitleitung BL entspricht, muß somit eine andere Dimensionierung der Rippenbreite der Rippen FIN1, FIN2 sowie der Wortleitungen WL1, WL2 und des Wortleitungsabstands gewählt werden. Da die Bitleitungen BL in einem Winkel von 45° zu der Wortleitungslängsrichtung (WL) und der Rippenlängsrichtung (FIN) verlaufen, betragen die Rippen- und Wortleitungsbreite sowie der Wortleitungsabstand $F\sqrt{2}$. Damit vergrößert sich die Speicherzelle auf eine $2F\sqrt{2} \times F\sqrt{2} = 8F^2$-Speicherzelle. Die Integrationsdichte des in Fig. 6 dargestellten Speicherzellenfeldes in "virtual ground array (VGA)" Anordnung ist somit geringer als diejenige von Fig. 4. Jedoch ist der Herstellungsprozeß aufgrund der lediglich einen notwendigen Bitleitungsebene einfacher.

**Bezugszeichenliste**

| | |
|---|---|
| 10 | Rippenoberseite |
| 12 | Rippenseitenflächen |
| 14 | Speicherschicht (trapping layer), z.B. Nitrid |
| 16 | Isolatorschicht, z.B. Oxid |
| 18 | Isolatorschicht zwischen Rippenoberseite und Speicherschicht |
| 20 | Isolatorschicht |
| 22 | erstes Bitleitungsteilstück |
| 24 | zweites Bitleitungsteilstück |

| | |
|---|---|
| BL | Bitleitung |
| (BL1) | erste Bitleitungsrichtung |
| (BL2) | zweite Bitleitungsrichtung |
| BOX | vergrabenen Oxidschicht |
| FIN | stegartige Rippe aus Halbleitermaterial |
| (FIN) | Rippenlängsrichtung |
| KL_E | Kontaktlochebene |
| M1_E | erste Metall- bzw. Bitleitungsebene |
| M2_E | zweite Metall- bzw. Bitleitungsebene |
| S/D | Kontaktbereiche |
| WL | Wortleitung |
| (WL) | Richtung der Wortleitung |

**Patentansprüche**

1.  Halbleiterspeicher mit

    - einer Vielzahl voneinander beabstandeter stegartiger Rippen (FIN) aus Halbleitermaterial, deren Rippenlängsrichtungen ((FIN)) parallel zueinander verlaufen, wobei in jeder der Rippen (FIN) eine Vielzahl von Kanalbereichen und leitfähig dotierten Kontaktbereichen (S/D) ausgebildet ist und die Kanal- und die Kontaktbereiche in Rippenlängsrichtung ((FIN)) alternierend hintereinander angeordnet sind;
    - einer Vielzahl von senkrecht zu der Rippenlängsrichtung ((FIN)) angeordneten zueinander parallelen Wortleitungen (WL), welche als Gateelektroden über eine Vielzahl der Kanalbereiche zur Steuerung von deren elektrischen Leitfähigkeiten verlaufen, wobei die Wortleitungen (WL) gegenüber den Kontakt- und den Kanalbereichen elektrisch isoliert sind;
    - einer Vielzahl von zum Einfangen und Abgeben von Ladungsträgern ausgelegten Speicherschichten (14), wobei zwischen jedem der Kanalbereiche und der diesem Kanalbereich zugeordneten Wortleitung (WL) zumindest eine der Speicherschichten (14) umgeben von einer Isolatorschicht (16, 18) angeordnet ist; und
    - einer Vielzahl von Bitleitungen (BL),

    -- welche schräg zur Wortleitungslängsrichtung ((WL)) und schräg zu der Rippenlängsrichtung ((FIN)) angeordnet sind,
    -- wobei die Bitleitungen (BL) jeweils aus zumindest einem ersten und einem zweiten Bitleitungsteilstück (22, 24) bestehen,
    -- die Längsachsen der ersten Bitleitungsteilstücke (22) parallel zu einer ersten ((BL1)) und die Längsachsen der zweiten Bitleitungsteilstücke (24) parallel zu einer zweiten ((BL2)) Bitleitungsrichtung verlaufen, wobei die zweite Bitleitungsrichtung ((BL2)) um einen von Null Grad verschiedenen Winkel gegenüber der ersten Bitleitungsrichtung ((BL1)) verdreht ist; und jede der Bitleitungen (BL) mit einer Vielzahl der Kontaktbereiche (S/D) elektrisch verbunden ist, wobei zwischen zwei mit einer der Bitleitungen (BL) verbundenen Kontaktbereichen (S/D) derselben Rippe (FIN) ein nicht mit dieser Bitleitung (BL) verbundener Kontaktbereich (S/D) angeordnet ist.

2.  Halbleiterspeicher nach Anspruch 1, wobei jede der Bitleitungen (BL) aus einer Vielzahl von Bitleitungsteilstücken (22, 24) mit alternierender erster ((BL1)) und zweiter ((BL2)) Bitleitungsrichtung besteht.

3.  Halbleiterspeicher nach einem der vorangegangenen Ansprüche, wobei die Bitleitungsteilstücke (22, 24) identische Längen aufweisen.

4.  Halbleiterspeicher nach einem der vorangegangenen Ansprüche, wobei eine Anzahl $N_{Rippen}$ der Rippen (FIN) in jedem Speichersektor vorgesehen ist und jedes der Bitleitungsteilstücke (22, 24) mit höchstens $N_{Rippen}/10$ von in Bitleitungsrichtung ((BL1), (BL2)) benachbarten Kontaktbereichen (S/D) unterschiedlicher Rippen (FIN) elektrisch verbunden ist.

5.  Halbleiterspeicher nach einem der vorangegangenen Ansprüche, wobei die Bitleitungen (BL) identische Flächengestalten aufweisen.

**6.** Halbleiterspeicher nach einem der vorangegangenen Ansprüche, wobei jede der Bitleitungen (BL) mit mindestens $N_{min}$ und höchstens $N_{max}$ der Kontaktbereiche (S/D) verbunden ist, so daß $(N_{max}-N_{min}) / N_{max} < 20\%$ gilt.

**7.** Halbleiterspeicher nach einem der vorangegangenen Ansprüche, wobei die Rippenbreite gleich der Wortleitungsbreite und gleich dem senkrechten Abstand zwischen benachbarten Wortleitungen (WL) ist.

**8.** Halbleiterspeicher nach einem der vorangeganenen Ansprüche, wobei zwei Bitleitungsebenen (M1_E, M2_E) vorgesehen sind und in Wortleitungslängsrichtung ((WL)) benachbarte Bitleitungen (BL) in unterschiedlichen Bitleitungsebenen (M1_E, M2_E) angeordnet sind.

**9.** Halbleiterspeicher nach einem der vorangegangenen Ansprüche, wobei die Bitleitungsrichtungen ((BL1), (BL2)) gegenüber der Wortleitungs- und der Rippenlängsrichtung um einen Winkel von etwa 45 Grad verdreht sind und der Winkel zwischen der ersten ((BL1)) und der zweiten ((BL2)) Bitleitungsrichtung 90 Grad beträgt.

**10.** Halbleiterspeicher nach einem der vorangegangenen Ansprüche, wobei die Speicherschichten (14) Trapping-Schichten und die Isolatorschichten (16, 18) Oxidschichten sind.

**11.** Halbleiterspeicher nach Anspruch 9, wobei das Halbleitermaterial Silizium, die Trapping-Schichten Siliziumnitridschichten und die Oxidschicht Siliziumdioxidschichten sind.

**Claims**

**1.** Semiconductor memory having

- a multiplicity of ridgelike fins (FIN) made of semiconductor material which are spaced apart from one another and the fin longitudinal directions ((FIN)) of which run parallel to one another, a multiplicity of channel regions and conductively doped contact regions (S/D) being formed in each of the fins (FIN) and the channel and contact regions being arranged alternately one after the other in the fin longitudinal direction ((FIN));
- a multiplicity of word lines (WL) which are arranged perpendicular to the fin longitudinal direction ((FIN)), are parallel to one another and, as gate electrodes, run over a multiplicity of the channel regions in order to control the electrical conductivities thereof, the word lines (WL) being electrically insulated from the contact and channel regions;
- a multiplicity of storage layers (14) designed for trapping and outputting charge carriers, at least one of the storage layers (14) being arranged in a manner surrounded by an insulator layer (16, 18) between each of the channel regions and the word line (WL) assigned to this channel region; and
- a multiplicity of bit lines (BL)

-- which are arranged obliquely with respect to the word line longitudinal direction ((WL)) and obliquely with respect to the fin longitudinal direction ((FIN)),
-- the bit lines (BL) in each case comprising at least one first and one second bit line portion (22, 24),
-- the longitudinal axes of the first bit line portions (22) running parallel to a first bit line direction ((BL1)) and the longitudinal axes of the second bit line portions (24) running parallel to a second bit line direction ((BL2)), the second bit line direction ((BL2)) being rotated by an angle that differs from zero degrees relative to the first bit line direction ((BL1)); and
-- each of the bit lines (BL) being electrically connected to a multiplicity of the contact regions (S/D), there being arranged, between two contact regions (S/D) of the same fin (FIN) that are connected to one of the bit lines (BL), a contact region (S/D) that is not connected to this bit line (BL).

**2.** Semiconductor memory according to Claim 1, each of the bit lines (BL) comprising a multiplicity of bit line portions (22, 24) having alternately a first ((BL1)) and second ((BL2)) bit line direction.

**3.** Semiconductor memory according to one of the preceding claims, the bit line portions (22, 24) having identical lengths.

**4.** Semiconductor memory according to one of the preceding claims, a number $N_{fins}$ of the fins (FIN) being provided in each memory sector and each of the bit line portions (22, 24) being electrically connected to at most $N_{fins}/10$ of contact regions (S/D) of different fins (FIN) that are adjacent in the bit line direction ((BL1), (BL2)).

**5.** Semiconductor memory according to one of the preceding claims, the bit lines (BL) having identical area configurations.

**6.** Semiconductor memory according to one of the preceding claims, each of the bit lines (BL) being connected to at least $N_{min}$ and at most $N_{max}$ of the contact regions (S/D), so that $(N_{max}-N_{min})/N_{max} < 20\%$ holds true.

7. Semiconductor memory according to one of the preceding claims, the fin width being equal to the word line width and equal to the perpendicular distance between adjacent word lines (WL).

8. Semiconductor memory according to one of the preceding claims, two bit line planes (M1_E, M2_E) being provided and bit lines (BL) that are adjacent in the word line longitudinal direction ((WL)) being arranged in different bit line planes (M1_E, M2_E).

9. Semiconductor memory according to one of the preceding claims, the bit line directions ((BL1), BL2)) being rotated by an angle of approximately 45 degrees relative to the word line and fin longitudinal directions and the angle between the first ((BL1)) and the second ((BL2)) bit line direction being 90 degrees.

10. Semiconductor memory according to one of the preceding claims, the storage layers (14) being trapping layers and the insulator layers (16, 18) being oxide layers.

11. Semiconductor memory according to Claim 9, the semiconductor material being silicon, the trapping layers being silicon nitride layers and the oxide layer being silicon dioxide layers.

**Revendications**

1. Mémoire à semi-conducteur, qui présente :

- plusieurs nervures (FIN) en forme d'ailette situées à distance les unes des autres, en matériau semi-conducteur, dont les directions longitudinales ((FIN)) s'étendent parallèlement les unes aux autres, plusieurs zones de canal et zones de contact (S/D) dopées de manière à être conductrices étant formées dans chacune des nervures (FIN), les zones de canal et les zones de contact étant disposées en alternance les unes derrière les autres dans la direction longitudinale ((FIN)) des nervures,
- plusieurs conducteurs de mot (WL) disposés parallèlement les uns aux autres et perpendiculairement à la direction longitudinale ((FIN)) des nervures, servant d'électrodes de grille et s'étendant sur plusieurs zones de canal pour commander leur conductivité électrique, les conducteurs de mot (WL) étant isolés électriquement par rapport aux zones de contacts et de canal,
- plusieurs couches de mémoire (14) conçues pour reprendre et délivrer des porteurs de charge, au moins une des couches de mémoire (14) étant entourée par une couche isolante (16, 18) entre chacune des zones de canal et le conducteur de mot (WL) associé à cette zone de canal, et
- plusieurs conducteurs de bits (BL),

- qui sont disposés obliquement par rapport à la direction longitudinale des conducteurs de mot ((WL)) et obliquement par rapport à la direction longitudinale ((FIN)) des nervures,
- les conducteurs de bits (BL) étant chacun constitués d'au moins une première et une deuxième pièce partielle (22, 24) de conducteur de bits,
- l'axe longitudinal des premières pièces partielles (22) de conducteur de bits étant parallèle à une première direction ((BL1)) des conducteurs de bits et l'axe longitudinal des deuxièmes pièces partielles (24) de conducteur de bits étant parallèle à une deuxième direction ((BL2)) de conducteurs de bits, la deuxième direction ((BL2)) de conducteurs de bits étant tournée par rapport à la première direction ((BL1)) de conducteurs de bits d'un angle différent de zéro degré et chacun des conducteurs de bits (BL) étant relié électriquement à plusieurs zones de contact (S/D), une zone de contact (S/D) non reliée à ce conducteur de bits (BL) étant disposée entre deux zones de contact (S/D) reliées à l'un des conducteurs de bits (BL) de la même nervure (FIN).

2. Mémoire à semi-conducteurs selon la revendication 1, dans laquelle chacun des conducteurs de bits (BL) est constitué de plusieurs pièces partielles (22, 24) de conducteurs de bits qui présentent en alternance une première direction ((BL1)) de conducteurs de bits et une deuxième direction ((BL2)) de conducteurs de bits.

3. Mémoire à semi-conducteurs selon l'une des revendications précédentes, dans laquelle les pièces partielles (22, 24) de conducteurs de bits ont la même longueur.

4. Mémoire à semi-conducteurs selon l'une des revendications précédentes, dans laquelle un nombre $N_{nervures}$ de nervures (FIN) est prévu dans chaque secteur de mémoire, chacune des pièces partielles (22, 24) de conducteur de bits étant reliée électriquement à au plus $N_{nervures}/10$ de zones de contact (S/D) voisines dans la direction ((BL1), (BL2)) des conducteurs de bits de nervures (FIN) différentes.

5. Mémoire à semi-conducteurs selon l'une des revendications précédentes, dans laquelle les conducteurs de bits (BL) ont une surface de forme identique.

6. Mémoire à semi-conducteurs selon l'une des revendications précédentes, dans laquelle chacun des conducteurs de bits (BL) est relié à au moins $N_{min}$ et à au plus $N_{max}$ zones de contact (S/D), de telle sorte que $(N_{max} - N_{min}) / Nmax < 20\%$.

7. Mémoire à semi-conducteurs selon l'une des revendications précédentes, dans laquelle la largeur des nervures est identique à la largeur des conducteurs de bits et est identique à la distance perpendiculaire entre les conducteurs de mots (WL) voisins.

8. Mémoire à semi-conducteurs selon l'une des revendications précédentes, dans laquelle deux plans (M1_E, M2_E) de conducteurs de bits sont prévus, des conducteurs de bits (BL) voisins étant disposés dans des plans (M1_E, M2_E) de conducteurs de bits différents dans le sens de la longueur ((WL)) des conducteurs de mots.

9. Mémoire à semi-conducteurs selon l'une des revendications précédentes, dans laquelle les directions ((BL1), (BL2)) des conducteurs de bis sont tournées d'un angle d'environ 45 degrés par rapport à la direction des conducteurs de mots et de la longueur des nervures, l'angle entre la première direction ((BL1)) des conducteurs de bits et la deuxième direction ((BL2)) des conducteurs de bits étant de 90 degrés.

10. Mémoire à semi-conducteurs selon l'une des revendications précédentes, dans laquelle les couches de mémoire (14) sont des couches de piégeage et les couches isolantes (16, 18) des couches d'oxyde.

11. Mémoire à semi-conducteurs selon la revendication 9, dans laquelle le matériau semi-conducteur est le silicium, les couches de piégeage sont des couches de nitrure de silicium et la couche d'oxyde une couche de dioxyde de silicium.

**10**

FIG 1

(WL) →

16    20
18
14    10
12    12

WL      FIN        FIN    WL

BOX

FIG 2

20

16
14    10
12    12    18

FIN        WL

BOX

## FIG 3

FIG 4

EP 1 535 334 B1

## FIG 5

M2_E

M1_E  BL1

KL_E  KL1

FIN_E  FIN1

BL2

KL2

FIN2

BL3

KL3

FIN3

## FIG 6

(FIN)

S/D

(WL)

WL2

$2F\sqrt{2}$  $2F\sqrt{2}$

S/D

WL1

F

FIN1  BL1  FIN2  BL2

**IN DER BESCHREIBUNG AUFGEFÜHRTE DOKUMENTE**

**In der Beschreibung aufgeführte Patentdokumente**

- DE 10211931
- US 5959328 A
- US 6274453 B1
- JP 8017942 A
- WO 9907000 A

**In der Beschreibung aufgeführte Nicht-Patentliteratur**

- **B. EITAN et al.** NROM: A novel localized trapping, 2-bit nonvolatile Memory Cell. *IEEE Electron Device Letters,* November 2000, vol. 21 (11